# DEMANDE DE BREVET EUROPEEN

(11) **EP 3 965 144 A1**
(43) Date de publication de la demande: **09.03.2022**
(21) Numéro de dépôt: 21194255.2
(22) Date de dépôt: 01.09.2021
(51) Int. Cl.: H01L 21/3065, H01L 29/66

(54) **PROCEDE DE GRAVURE D'UNE COUCHE DE MATERIAU III-N**

(30) Priorité: 03.09.2020 FR 2008958
(71) Demandeur: Commissariat à l'énergie atomique et aux énergies alternatives, 75015 Paris (FR)
(72) Inventeur: POSSEME, Nicolas, 38054 GRENOBLE CEDEX 09 (FR); RUEL, Simon, 38054 GRENOBLE CEDEX 09 (FR)
(74) Mandataire: Brevalex

(57) **Abrégé**

Procédé de gravure d'au moins une portion d'une couche de matériau III-N, comportant la mise en œuvre des étapes suivantes :
a) première gravure (102) d'une première partie de l'épaisseur de la portion de la couche de matériau III-N, mise en œuvre en utilisant un premier plasma comportant du chlore ;
b) exposition (104) d'au moins une partie d'une épaisseur restante de la portion de la couche de matériau III-N à un deuxième plasma comportant de l'hélium ou de l'hydrogène ;
c) chloration (106) de la partie de l'épaisseur restante de la portion de la couche de matériau III-N, transformant la partie de l'épaisseur restante de la portion de la couche de matériau III-N en une couche de matériau chloré ;
d) deuxième gravure (108) de la couche de matériau chloré, mise en œuvre en utilisant un troisième plasma comportant de l'argon.

## Description

### DOMAINE TECHNIQUE

L'invention concerne un procédé de gravure d'une couche de matériau III-N. L'invention concerne également un procédé de réalisation d'un ou plusieurs composants électroniques de puissance au cours duquel ce procédé de gravure est mis en œuvre.

### ART ANTERIEUR

Grâce à leurs propriétés électriques meilleures que celles des structures à base de silicium ou de SiC, les hétérostructures AlGaN/GaN, qui permettent la formation d'un gaz d'électrons bi-dimensionnel, représentent un choix judicieux pour la réalisation de composants électroniques de puissance tels que des transistors de type HEMT (« High-Electron-Mobility Transistor» en anglais, ou transistor à haute mobilité d'électrons) ou des diodes. Les avantages apportés par ce type d'hétérostructure sont notamment une taille réduite des composants pouvant être réalisés, une bonne tenue en tension, une importante mobilité de porteurs ainsi qu'une faible résistance série.

Cette hétérostructure, lorsqu'elle est utilisée pour réaliser un transistor ou une diode, est gravée pour former les emplacements de la grille et des contacts électriques du transistor, ou pour former les emplacements des contacts électriques de la diode. Pour cela, une gravure par plasma est mise en œuvre dans un équipement de type ICP ("Inductive Coupled Plasma", ou plasma à couplage inductif) en utilisant un plasma chloré, par exemple à base de SiCl₄ ou de BCl₃. La vitesse d'une telle gravure est élevée grâce à la désorption des espèces GaCl₃ et AlCl₃ qui sont volatiles. Toutefois, elle induit des défauts dans l'hétérostructure gravée, comme par exemple : création de défauts structurels, modification de stœchiométrie ou encore implantation d'éléments et génération de charges dans les matériaux gravés. Ces défauts modifient les propriétés électriques des matériaux gravés et dégradent celles du dispositif réalisé à partir de l'hétérostructure gravée, comme par exemple le canal du transistor lorsque cette gravure est mise en œuvre pour réaliser la grille du transistor. De plus, une telle gravure plasma ne permet pas un bon contrôle de la profondeur de matériau gravé en raison de l'absence de couche d'arrêt de gravure dans la structure gravée, cette profondeur étant déterminée par la durée pendant laquelle la gravure est mise en œuvre.

Les documents "Reactive ion etching of gallium nitride using hydrogen bromide plasmas" de A. T. Ping et al. Electron. Lett., vol. 30, no. 22, pp. 1895-1897, 1994, et "Reactive ion etching of GaN using CHF3/Ar and C2ClF5/Ar plasmas" de H. Lee et al., Appl. Phys. Lett., vol. 67, p. 1754, 1995, décrivent la possibilité de graver du GaN en utilisant des plasmas à base de brome ou de fluor. Les vitesses de gravure obtenues sont toutefois bien inférieures à celles obtenues en utilisant des plasmas à base de chlore en raison des espèces formées qui sont plus difficiles à désorber que celles formées par les plasmas à base de chlore. Une augmentation de l'énergie ionique du plasma utilisé permet d'augmenter la vitesse de gravure, mais engendre des défauts dans le matériau gravé.

Pour pallier à ces problèmes, le document "Atomic layer etching of GaN and AIGaN using directional plasma-enhanced approach," de T. Ohba et al., Jpn. J. Appl. Phys., vol. 56, no. 6, 2017 propose de mettre en œuvre une gravure plasma chlorée classique suivie d'une sur-gravure de type ALE ("Atomic Layer Etching", ou gravure de couche atomique) pour graver une couche de GaN. Cette sur-gravure est obtenue en répétant de manière cyclique les deux étapes suivantes :
- une chloration par un plasma Cl₂/BCl₃ de la surface de GaN destinée à être gravée, modifiant le GaN sur une faible épaisseur et formant une fine couche à base de Cl₂ ;
- une gravure de la couche à base de Cl₂ sélectivement par rapport au GaN se trouvant sous la couche à base de Cl₂ et qui n'a pas été modifié par l'étape de chloration précédente, mise en œuvre par un plasma à base d'Ar avec une faible polarisation.

Entre chacune des deux étapes de chaque cycle de la sur-gravure, il est nécessaire de réaliser une purge et une stabilisation des gaz pendant environ 10 secondes. Pendant cette phase, le plasma est coupé afin d'éviter les interactions et les mélanges de gaz. Compte tenu des nombreux cycles de sur-gravure à mettre en œuvre pour graver l'épaisseur souhaitée (du fait que l'épaisseur de matériau gravée à chaque cycle est de l'ordre de 0,5nm), le temps nécessaire pour mettre en œuvre ce procédé représente un inconvénient majeur. De plus, la gamme de valeurs de l'énergie ionique avec laquelle la gravure des couches à base de Cl₂ doit être mise en œuvre pour graver complètement la couche à base de Cl₂ sans endommager le GaN sous-jacent est très restreinte.

### EXPOSÉ DE L'INVENTION

Un but de la présente invention est de proposer un procédé de gravure d'au moins une portion d'une couche de matériau III-N qui soit plus rapide qu'une gravure mise en œuvre avec un plasma à base de brome ou de fluor ou qui met en œuvre une sur-gravure de type ALE, et qui permet d'obtenir une meilleure précision de l'épaisseur de matériau gravé qu'une gravure par plasma à base de chlore.

Pour cela, il est proposé un procédé de gravure d'au moins une portion d'une couche de matériau III-N, comportant la mise en œuvre des étapes suivantes :
a) première gravure d'une première partie de l'épaisseur de la portion de la couche de matériau III-N, mise en œuvre en utilisant un premier plasma comportant du chlore ;
b) exposition d'au moins une partie d'une épaisseur restante de la portion de la couche de matériau III-N à un deuxième plasma comportant de l'hélium ou de l'hydrogène ;
c) chloration de la partie de l'épaisseur restante de la portion de la couche de matériau III-N, transformant la partie de l'épaisseur restante de la portion de la couche de matériau III-N en une couche de matériau chloré ;
d) deuxième gravure de la couche de matériau chloré, mise en œuvre en utilisant un troisième plasma comportant de l'argon.

Ce procédé propose de mettre en œuvre une première gravure de la portion de la couche de matériau III-N en utilisant un premier plasma comportant du chlore afin de graver rapidement une première partie de l'épaisseur de la portion de la couche de matériau III-N à graver. Dans l'étape a), c'est le premier plasma comportant du chlore qui grave, ou retire, le matériau de la première partie de l'épaisseur de la portion de la couche de matériau III-N. Les étapes b), c) et d) qui sont ensuite mises en œuvre une ou plusieurs fois achèvent la gravure de la portion de la couche de matériau III-N.

Par rapport à une gravure utilisant seulement un plasma chloré, les dommages engendrés dans le matériau gravé par le procédé selon l'invention ne sont pas plus importants, voire inférieurs, et le procédé de gravure selon l'invention permet d'avoir un meilleur contrôle de la profondeur de matériau gravé du fait que cette profondeur est définie par l'épaisseur de matériau exposé lors de l'étape b).

Par rapport aux gravures utilisant des plasmas à base de brome ou de fluor, la vitesse de gravure obtenue avec le procédé selon l'invention est supérieure, et cela sans avoir à augmenter l'énergie ionique des plasmas utilisés qui pourrait engendrer beaucoup de défauts dans le matériau gravé.

Enfin, par rapport au procédé faisant appel à une sur-gravure de type ALE utilisant des plasmas à base de Cl₂ et Ar, le procédé proposé ici permet d'avoir une plus grande vitesse de gravure du fait que l'épaisseur de matériau pouvant être gravée lors de la mise en œuvre des étapes b), c) et d) est bien supérieure à celle pouvant être gravée lors d'un cycle de sur-gravure ALE.

Les étapes b), c) et d) peuvent être répétées une ou plusieurs fois jusqu'à obtenir une profondeur de gravure souhaitée.

L'étape b) et/ou l'étape d) peuvent être mises en œuvre en soumettant le deuxième plasma et/ou le troisième plasma à une tension de polarisation comprise entre 20 V et 100 V. De telles tensions de polarisation permettent de limiter les défauts créés dans le matériau.

La partie de l'épaisseur restante de la portion de la couche de matériau III-N peut avoir une épaisseur comprise entre 5 nm et 10 nm.

L'étape c) peut être mise en œuvre en utilisant une solution chlorée ou un quatrième plasma comportant du Cl₂ et/ou du BCl₃.

Les étapes b), c) et d), et éventuellement l'étape a), peuvent être mises en œuvre dans un seul équipement de gravure de type ICP-RIE ("Inductive Coupled Plasma - Reactive Ion Etching", ou gravure ionique réactive à plasma à couplage inductif).

L'étape b) et/ou l'étape d) peuvent être mises en œuvre avec un plasma pulsé. L'utilisation d'un plasma pulsé permet de réduire l'endommagement de la couche gravée pour une tension d'auto-polarisation donnée, et de réduire l'endommagement par rapport à un plasma continu.

L'étape b) et/ou l'étape d) peuvent être mises en œuvre :
- en utilisant une source de puissance comprise entre 100 W et 1000 W, et/ou
- dans une chambre de gravure dans laquelle la pression est comprise entre 0,67 Pa et 6,67 Pa, et/ou
- avec un flux de plasma compris entre 10 sccm et 500 sccm, et/ou
- pendant une durée comprise entre 5 s et 20 s,
et/ou dans lequel l'étape c) peut être mise en œuvre :
- en utilisant une source de puissance comprise entre 100 W et 1000 W, et/ou
- dans une chambre de gravure dans laquelle la pression est comprise entre 1,33 Pa et 13,33 Pa, et/ou
- avec un flux compris entre 10 sccm et 500 sccm, et/ou
- pendant une durée comprise entre 5 s et 30 s.

Le procédé est avantageusement mis en œuvre pour graver une couche de matériau III-N comportant du GaN et/ou de l'AlGaN et/ou de l'AIN.

En outre, la couche de matériau III-N peut faire partie d'une hétérostructure AlGaN/GaN.

L'invention concerne également un procédé de réalisation d'au moins un composant électronique de puissance, comportant la mise en œuvre des étapes suivantes :
- réalisation d'une hétérostructure AlGaN/GaN ;
- réalisation d'emplacements de contacts électriques du composant d'électronique de puissance dans l'hétérostructure AlGaN/GaN, comportant la mise en œuvre d'un procédé de gravure tel que décrit ci-dessus.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement les étapes d'un procédé de gravure d'au moins une portion d'une couche de matériau III-N, objet de la présente invention, selon un mode de réalisation particulier;
- les figures 2 à 7 représentent schématiquement les étapes d'une partie d'un procédé de réalisation d'un composant électronique de puissance, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

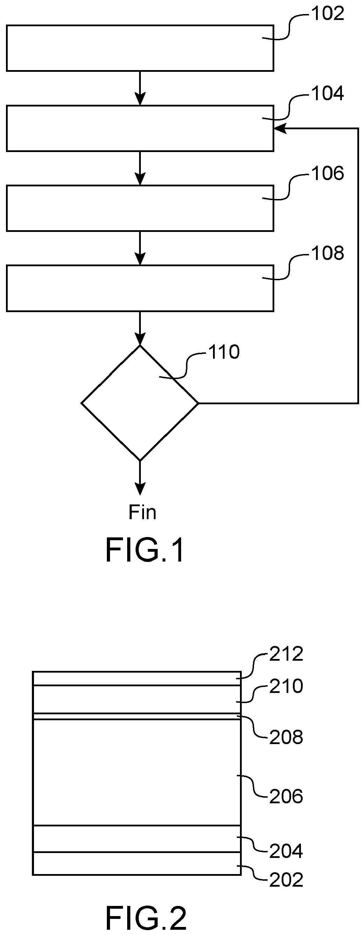

La figure 1 décrite ci-dessous représente schématiquement les étapes d'un procédé de gravure d'au moins une portion d'au moins une couche de matériau III-N selon un mode de réalisation particulier.

La couche de matériau III-N correspond ici à une couche de GaN et/ou d'AlGaN et/ou d'AIN. D'autres matériaux III-N peuvent toutefois être gravés avec le procédé décrit ci-dessous.

L'épaisseur de la portion de la couche de matériau III-N destinée à être gravée est par exemple comprise entre 20 nm et 400 nm.

Ce procédé de gravure est ici mis en œuvre dans un seul équipement de gravure de type RIE, et avantageusement de type ICP-RIE.

Une première partie de l'épaisseur de la portion de la couche de matériau III-N est tout d'abord gravée lors d'une première gravure 102. Cette première gravure 102 est mise en œuvre en utilisant un premier plasma comportant du chlore, avec l'ajout par exemple de BCl₃ ou de SiCl₄.

Cette première gravure 102 est mise en œuvre pendant une durée suffisante pour graver une grande partie de l'épaisseur de la portion de la couche de matériau III-N destinée à être gravée, par exemple entre environ 80 % et 90 % de cette épaisseur. La valeur de l'épaisseur restante à gravée (à l'issue de la première gravure) de la portion de la couche de matériau III-N peut être comprise entre environ 5 nm et 50 nm.

Après avoir mis en œuvre cette première gravure 102, une exposition 104 d'au moins une partie de l'épaisseur restante de la portion de la couche de matériau III-N à un deuxième plasma comportant de l'hélium ou de l'hydrogène est mise en œuvre. En exposant ainsi le matériau III-N à l'hélium ou à l'hydrogène, le matériau III-N subit une amorphisation et est endommagé par l'hélium ou l'hydrogène utilisé, créant des défauts dans le matériau III-N qui forment des liaisons atomiques cassées et/ou pendantes. Cette modification du matériau III-N est réalisée sur une épaisseur par exemple comprise entre 5 nm et 10 nm.

Lors de cette étape 104 exposant le matériau III-N au deuxième plasma comportant de l'hélium ou de l'hydrogène, le deuxième plasma peut être soumis à une tension de polarisation comprise entre 20 V et 100 V, et avantageusement égale à 50 V.

Cette étape 104 est par exemple mise en œuvre :
- en utilisant une source de puissance comprise entre 100 W et 000 W, et avantageusement égale à 100 W, et/ou
- dans une chambre de gravure dans laquelle la pression est comprise entre 0,67 Pa et 6,67 Pa, et avantageusement égale à 1,33 Pa, et/ou
- avec un flux de plasma compris entre 10 sccm et 500 sccm, et avantageusement égal à 200 sccm, et/ou
- pendant une durée comprise entre 5 s et 20 s, et avantageusement égale à 5 s.

Une étape de chloration 106 de la partie de l'épaisseur restante de la portion de la couche de matériau III-N modifiée par la précédente étape 104 est ensuite mise en œuvre, transformant cette partie de l'épaisseur restante de la portion de la couche de matériau III-N en une couche de matériau chloré. Le chlore auquel le matériau III-N endommagé est exposé est adsorbé grâce aux liaisons atomiques cassées et/ou pendantes précédemment formées par la mise en œuvre de l'étape 104.

L'épaisseur de la couche de matériau chloré obtenue est sensiblement égale à celle du matériau III-N précédemment endommagé, c'est-à-dire comprise par exemple entre 5 nm et 10 nm.

L'étape de chloration 106 peut être mise en œuvre en utilisant une solution chlorée ou un quatrième plasma comportant du Cl₂ et/ou du BCl₃.

Cette étape de chloration 106 est par exemple mise en œuvre :
- en utilisant une source de puissance comprise entre 100 W et 1000 W, et avantageusement égale à 100 W, et/ou
- dans une chambre de gravure dans laquelle la pression est comprise entre 1,33 Pa et 13,33 Pa, et avantageusement égale à 8 Pa, et/ou
- avec un flux compris entre 10 sccm et 500 sccm, et avantageusement égal à 200 sccm, et/ou
- pendant une durée comprise entre 5 s et 30 s, c'est-à-dire le temps nécessaire pour adsorber le chlore sur toute la zone de matériau III-N précédemment endommagée.

Une deuxième gravure 108 de la couche de matériau chloré obtenue à l'issue de la précédente étape de chloration 106 est ensuite mise en œuvre en utilisant un troisième plasma comportant de l'argon. Cette deuxième gravure 108 permet de graver toute l'épaisseur de la couche de matériau chloré.

Lors de cette deuxième gravure 108, le troisième plasma comportant de l'argon peut être soumis à une tension de polarisation comprise entre 20 V et 100 V, et avantageusement égale à 50 V.

Cette deuxième gravure 108 est par exemple mise en œuvre :
- en utilisant une source de puissance comprise entre 100 W et 1000 W, et avantageusement égale à 100 W, et/ou
- dans une chambre de gravure dans laquelle la pression est comprise entre 0,67 Pa et 6,67 Pa, et avantageusement égale à 1,33 Pa, et/ou
- avec un flux de plasma compris entre 10 sccm et 500 sccm, et avantageusement égal à 200 sccm, et/ou
- pendant une durée comprise entre 5 s et 20 s.

De manière optionnelle, entre les étapes 104 et 106 et/ou entre les étapes 106 et 108, une étape de stabilisation peut être mise en œuvre afin de stabiliser les gaz, la pression et la température avant de mettre en œuvre l'étape suivante. Cette phase de stabilisation peut être mise en œuvre pendant une durée de quelques secondes.

A l'étape 110, l'utilisateur décide si la profondeur de gravure souhaitée a été obtenue. Si c'est le cas, le procédé de gravure s'achève. Sinon, les étapes 104, 106 et 108 sont répétées une ou plusieurs fois jusqu'à obtenir la profondeur de gravure souhaitée dans la portion de la couche de matériau III-N.

Toutes les étapes du procédé décrit ci-dessus peuvent être mises en œuvre à une même température inférieure à 100°C, et avantageusement comprise entre 40°C et 60°C pour avoir une meilleure efficacité de modification des matériaux.

Lorsque les étapes du procédé sont mises en œuvre à une température de 40°C, chaque cycle de mise en œuvre des étapes 104-110 peut graver une épaisseur de matériau égale à environ 1,4 nm.

En variante du procédé décrit ci-dessus, l'exposition 104 du matériau III-N au deuxième plasma comportant de l'hélium ou de l'hydrogène et/ou la deuxième gravure 108 utilisant le troisième plasma comportant de l'argon peuvent être mises en œuvre avec un plasma pulsé. Un tel plasma pulsé peut être obtenu en faisant fonctionner par intermittence, c'est-à-dire de manière périodique, la source et/ou la polarisation. Il est possible d'ajuster les propriétés de ce plasma pulsé en modifiant le rapport cyclique (rapport entre la durée de mise en marche et la durée d'arrêt) et/ou la fréquence du signal commandant la puissance de la source, et/ou en modifiant le rapport cyclique et/ou la fréquence du signal de polarisation.

Le procédé de gravure décrit ci-dessus est avantageusement mis en œuvre lors de la réalisation de composants électroniques de puissance. Les figures 2 à 7 décrites ci-dessous illustrent des étapes mises en œuvre lors de la réalisation d'un composant électronique de puissance 200 permettant de graver une épaisseur donnée d'une hétérostructure AlGaN/GaN. Les étapes décrites en lien avec les figures 2 à 7 correspondent aux étapes mises en œuvre pour réaliser la grille d'un transistor HEMT.

Le transistor HEMT est réalisé à partir d'un empilement de couches comportant un substrat 202, une ou plusieurs couches tampon 204 disposées sur le substrat 202, et une hétérostructure AlGaN/GaN formée ici d'une couche de GaN 206 disposée sur la ou les couches tampon 204, d'une couche d'AIN 208 disposée sur la couche de GaN 206 et d'une couche d'AlGaN 210 disposée sur la couche d'AIN 208. Les couches 204, 206, 208 et 210 sont par exemple réalisées par épitaxie.

Le substrat 202 correspond à un substrat de semi-conducteur, par exemple du silicium. La ou les couches tampon 204, qui permettent de réduire les problèmes de désaccord de mailles et de coefficients de dilatation thermique entre le substrat 202 et l'hétérostructure AlGaN/GaN, comportent par exemple de l'AIN et/ou de l'AlGaN à différentes concentrations pour créer un gradient d'Al et/ou de Ga, ce qui permet de faire croître par épitaxie l'hétérostructure AlGaN/GaN dans de bonnes conditions.

L'épaisseur de l'hétérostructure AlGaN/GaN (couches 206, 208, 210) est par exemple comprise entre 300 nm et 1 µm.

Dans l'exemple décrit ici, la couche d'AlGaN 210 est recouverte d'une fine couche de passivation 212 de SiN, d'épaisseur par exemple égale à 10 nm, déposée in-situ dans le bâti d'épitaxie utilisé pour réaliser les couches 204, 206, 208 et 210, permettant de protéger la surface supérieure de la couche d'AlGaN 210, et d'éviter les relaxations ainsi que l'ouverture des dislocations en surface de la couche d'AlGaN 210. La structure obtenue à ce stade du procédé correspond à la structure visible sur la figure 2.

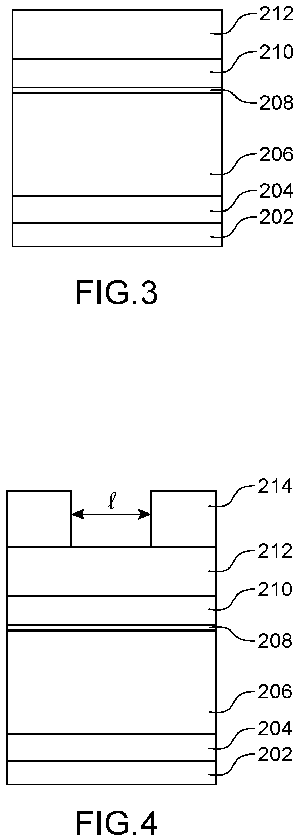

La couche de passivation 212 peut ensuite être achevée en déposant, par exemple par LPCVD (« Low-Pressure Chemical Vapor Déposition » en anglais, ou dépôt chimique en phase vapeur à basse pression), une épaisseur plus importante de matériau de passivation, ici du nitrure de silicium (Si₃N₄). L'épaisseur finale de la couche de passivation est par exemple comprise entre 10 nm et 100 nm. La structure obtenue à ce stade du procédé correspond à la structure visible sur la figure 3.

Un masque de gravure 214 est ensuite réalisé sur la couche de passivation 212. Le motif de ce masque de gravure 214 permet de définir la forme et l'emplacement de la grille du transistor réalisé. Ce motif correspond par exemple à celui d'une tranchée dont la largeur « l » est par exemple comprise entre 250 nm et 50 µm. Ce masque 214 est par exemple obtenu par lithographie d'une résine. La structure obtenue à ce stade du procédé correspond à la structure visible sur la figure 4.

Une gravure par plasma est mise en œuvre en utilisant un plasma fluorocarboné, par exemple du C₂F₆, du CHF₃ ou CF₄, avec un mélange d'autres gaz tels que de l'Ar, du N₂ ou du O₂, afin de graver la couche de passivation 212 conformément au motif du masque de gravure 214.

Les étapes précédemment décrites en lien avec la figure 1 sont ensuite mises en œuvre pour graver une partie de l'épaisseur de l'hétérostructure AlGaN/GaN formée par les couches 206, 208 et 210. Dans l'exemple décrit ici, ces étapes sont mises en œuvre afin de graver toute l'épaisseur des couches 210 et 208, et une partie de l'épaisseur de la couche 206. L'épaisseur totale gravée est par exemple comprise entre 20 nm et 400 nm.

La première gravure 102 mise en œuvre en utilisant un premier plasma comportant du chlore peut par exemple servir à graver toute l'épaisseur des couches 210 et 208, et à graver une grande partie de l'épaisseur souhaitée de la couche 206. Ainsi, les étapes 104, 106 et 108 mises en œuvre, une ou plusieurs fois, ne servent qu'à graver une épaisseur restante réduite du matériau de la couche 206 jusqu'à atteindre la profondeur souhaitée, et permettre ainsi d'atteindre avec précision la profondeur souhaitée.

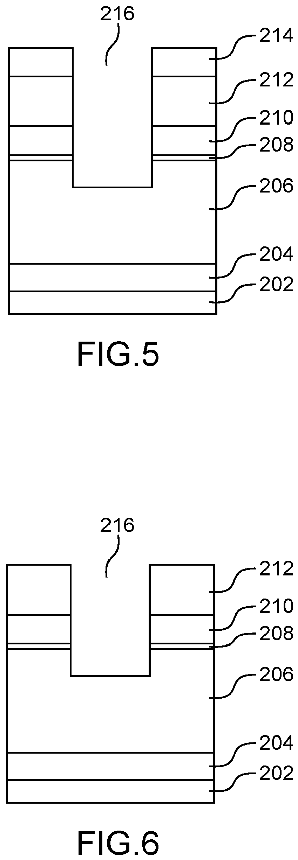

Les étapes mises en œuvre forment un emplacement de grille 216 dans l'hétérostructure AlGaN/GaN. Une partie de l'épaisseur du masque de gravure 214 est également consommée par ces étapes. La structure obtenue à ce stade du procédé correspond à la structure visible sur la figure 5.

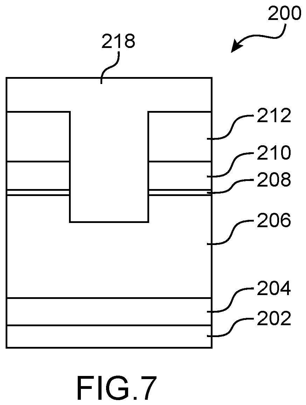

Le masque de gravure 214 est ensuite supprimé (structure obtenue visible sur la figure 6), puis les matériaux de grille (diélectrique de grille et conducteur de grille) sont déposés dans l'emplacement 216 et sur la couche de passivation 212, formant une grille 218. La structure obtenue à l'issue du procédé correspond à la structure visible sur la figure 7, et représente schématiquement le composant 200 réalisé.

Des étapes analogues peuvent être mises en œuvre pour la réalisation des contacts des régions de source et de drain du composant 200.

En variante, le procédé de gravure décrit ci-dessus peut être mis en œuvre pour réaliser les emplacements de contact d'un autre type de composant électronique de puissance 200, par exemple une diode.

## Revendications

1. Procédé de gravure d'au moins une portion d'une couche de matériau III-N (206, 208, 210), comportant la mise en œuvre des étapes suivantes :
a) première gravure (102) d'une première partie de l'épaisseur de la portion de la couche de matériau III-N (206, 208, 210), mise en œuvre en utilisant un premier plasma comportant du chlore ;
b) exposition (104) d'au moins une partie d'une épaisseur restante de la portion de la couche de matériau III-N (206, 208, 210) à un deuxième plasma comportant de l'hélium ou de l'hydrogène ;
c) chloration (106) de la partie de l'épaisseur restante de la portion de la couche de matériau III-N (206, 208, 210), transformant la partie de l'épaisseur restante de la portion de la couche de matériau III-N (206, 208, 210) en une couche de matériau chloré ;
d) deuxième gravure (108) de la couche de matériau chloré, mise en œuvre en utilisant un troisième plasma comportant de l'argon.

2. Procédé de gravure selon la revendication 1, dans lequel les étapes b), c) et d) (104, 106, 108) sont répétées une ou plusieurs fois jusqu'à obtenir une profondeur de gravure souhaitée.

3. Procédé de gravure selon l'une des revendications précédentes, dans lequel l'étape b) (104) et/ou l'étape d) (108) sont mises en œuvre en soumettant le deuxième plasma et/ou le troisième plasma à une tension de polarisation comprise entre 20 V et 100 V.

4. Procédé de gravure selon l'une des revendications précédentes, dans lequel la partie de l'épaisseur restante de la portion de la couche de matériau III-N (206, 208, 210) a une épaisseur comprise entre 5 nm et 10 nm.

5. Procédé de gravure selon l'une des revendications précédentes, dans lequel l'étape c) (106) est mise en œuvre en utilisant une solution chlorée ou un quatrième plasma comportant du Cl₂ et/ou du BCl₃.

6. Procédé de gravure selon l'une des revendications précédentes, dans lequel les étapes b), c) et d) (104, 106, 108) sont mises en œuvre dans un seul équipement de gravure de type ICP-RIE.

7. Procédé de gravure selon l'une des revendications précédentes, dans lequel l'étape b) (104) et/ou l'étape d) (108) sont mises en œuvre avec un plasma pulsé.

8. Procédé de gravure selon l'une des revendications précédentes, dans lequel l'étape b) (104) et/ou l'étape d) (108) sont mises en œuvre :
- en utilisant une source de puissance comprise entre 100 W et 1000 W, et/ou
- dans une chambre de gravure dans laquelle la pression est comprise entre 0,67 Pa et 6,67 Pa, et/ou
- avec un flux de plasma compris entre 10 sccm et 500 sccm, et/ou
- pendant une durée comprise entre 5 s et 20 s,
et/ou dans lequel l'étape c) (106) est mise en œuvre :
- en utilisant une source de puissance comprise entre 100 W et 1000 W, et/ou
- dans une chambre de gravure dans laquelle la pression est comprise entre 1,33 Pa et 13,33 Pa, et/ou
- avec un flux compris entre 10 sccm et 500 sccm, et/ou
- pendant une durée comprise entre 5 s et 30 s.

9. Procédé de gravure selon l'une des revendications précédentes, dans lequel la couche de matériau III-N (206, 208, 210) comporte du GaN et/ou de l'AlGaN et/ou de l'AIN.

10. Procédé de gravure selon l'une des revendications précédentes, dans lequel la couche de matériau III-N (206, 208, 210) fait partie d'une hétérostructure AlGaN/GaN.

11. Procédé de réalisation d'au moins un composant électronique de puissance (200), comportant la mise en œuvre des étapes suivantes :
- réalisation d'une hétérostructure AlGaN/GaN (206, 208, 210) ;
- réalisation d'emplacements (216) de contacts électriques (218) du composant d'électronique de puissance (200) dans l'hétérostructure AlGaN/GaN (206, 208, 210), comportant la mise en œuvre d'un procédé de gravure selon la revendication 10.
